(19) **Europäisches Patentamt / European Patent Office / Office européen des brevets**

(11) **EP 3 726 237 A2**

(12) **EUROPEAN PATENT APPLICATION**

(43) Date of publication:
**21.10.2020 Bulletin 2020/43**

(51) Int Cl.:
**G01R 33/00** (2006.01)          **G01R 33/022** (2006.01)
**G01R 33/09** (2006.01)

(21) Application number: **20168792.8**

(22) Date of filing: **08.04.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.04.2019 US 201916388167**

(71) Applicant: NXP B.V.
**5656 AG Eindhoven (NL)**

(72) Inventors:
• **REIMANN, Klaus**
  **Redhill, Surrey RH1 1QZ (GB)**
• **MATZ, Hartmut**
  **Redhill, Surrey RH1 1QZ (GB)**
• **ISLER, Mark**
  **Redhill, Surrey RH1 1QZ (GB)**
• **KOCK, Jörg**
  **Redhill, Surrey RH1 1QZ (GB)**

(74) Representative: **Hardingham, Christopher Mark**
**NXP Semiconductors**
**Intellectual Property Group**
**Abbey House**
**25 Clarendon Road**
**Redhill, Surrey RH1 1QZ (GB)**

(54) **MAGNETIC FIELD SENSOR, SYSTEM, AND METHOD FOR SPEED MEASUREMENT**

(57)    A sensor includes first and second magnetoresistive sensor elements configured to produce respective first and second output signals in response to an external magnetic field. The first and second magnetoresistive sensor elements form a gradient unit, each of the magnetoresistive sensor elements includes a sense layer having a vortex magnetization pattern. A processing circuit is coupled to the sensor elements and is configured to produce a differential output signal as a difference between the first and second output signals of the first and second magnetoresistive sensor elements of the gradient unit. The system includes an encoder that produces the external magnetic field and the sensor having one or more gradient units, in which the gradient units may be arranged in a second-order gradient sensing configuration.

*FIG. 3*

**Description**

**TECHNICAL FIELD OF THE INVENTION**

The present invention relates generally to magnetic field sensors. More specifically, the present invention relates to magnetoresistive sensors with their sense layers in a vortex state for measuring magnetic fields in a gradient configuration.

**BACKGROUND OF THE INVENTION**

Magnetic field sensor systems are utilized in a variety of commercial, industrial, and automotive applications to measure magnetic fields for purposes of speed and direction sensing, rotation angle sensing, proximity sensing, and the like. Some magnetic field sensors are based upon the magnetoresistive effect in which a material has a tendency to change the value of its electrical resistance in response to an externally-applied magnetic field. Magnetoresistive devices include, for example, Anisotropic Magneto Resistance (AMR) technology, Giant Magneto Resistance (GMR) technology, Tunnel Magneto Resistance (TMR) technology, and so forth.

**SUMMARY**

Aspects of the disclosure are defined in the accompanying claims.

In a first aspect, there is provided a sensor comprising a first magnetoresistive sensor element configured to produce a first output signal in response to an external magnetic field, a second magnetoresistive sensor element configured to produce a second output signal in response to the external magnetic field, wherein the first and second magnetoresistive sensor elements form a gradient unit, each of the first and second magnetoresistive sensor elements includes a sense layer having a vortex magnetization pattern, and a processing circuit electrically coupled to the first and second magnetoresistive sensor elements, wherein the processing circuit is configured to produce a differential output signal as a difference between the first and second output signals of the first and second magnetoresistive sensor elements of the gradient unit.

In a second aspect, there is provided a system comprising an encoder configured to produce an external magnetic field having predetermined magnetic variations in response to motion of the encoder and sensor. The sensor comprises a first magnetoresistive sensor element configured to produce a first output signal in response to the external magnetic field, a second magnetoresistive sensor element configured to produce a second output signal in response to the external magnetic field, the first and second magnetoresistive sensor elements form a gradient unit, each of the first and second magnetoresistive sensor elements includes a sense layer having a vortex magnetization pattern, and a processing circuit electrically coupled to the first and second magnetoresistive sensor elements, wherein the processing circuit is configured to produce a differential output signal as a difference between the first and second output signals of the first and second magnetoresistive sensor elements of the gradient unit.

In one or more embodiments, the gradient unit is a first gradient unit, the differential output signal is a first differential output signal, and the sensor further comprises: a third magnetoresistive sensor element configured to produce a third output signal in response to the external magnetic field, wherein a sense layer of the third magnetoresistive sensor element has the vortex magnetization pattern and the first and third magnetoresistive sensor elements form a second gradient unit, and wherein: the processing circuit is electrically coupled to the third magnetoresistive sensor element and is configured to: produce a second differential output signal as the difference between the second and third output signals of the second gradient unit; produce a sensor output signal as a difference between the first and second differential output signals; and generate a speed pulse indicative of a speed of an apparatus coupled to the encoder when the sensor output signal is zero.

In one or more embodiments the system further comprises: a first detector configured to receive the first output signal from the first magnetoresistive sensor element and determine from the first output signal whether the first magnetoresistive sensor element is operating in a safe range, the safe range being less than a nucleation field for the vortex magnetization pattern; a second detector configured to receive the second output signal from the second magnetoresistive sensor element and determine from the second output signal whether the second magnetoresistive sensor element is operating in the safe range; and a third detector configured to receive the second output signal from the second magnetoresistive sensor element and determine from the second output signal whether the second magnetoresistive sensor element is operating in the safe range, wherein: the processing circuit is electrically coupled with the first, second, and third detectors, the processing circuit being further configured to: produce a first flag when the first magnetoresistive sensor element is not operating in the safe range thereby indicating that the first output signal is invalid; produce a second flag when the second magnetoresistive sensor element is not operating in the safe range thereby indicating that the second output signal is invalid; produce a third flag when the third magnetoresistive sensor element is not operating in the safe range thereby indicating that the third output signal is invalid; produce a sensor output signal as the difference between the first and second differential output signals when all of the first, second, and third magnetoresistive sensor elements are operating in the safe range; discard any invalid ones of the first, second, and third output signals; and produce the sensor output signal with a remaining one or more of the first, second, and third output signals after the invalid ones of the first, second, and third output signals have been discarded.

In a third aspect, there is provided a method of determining speed of an apparatus comprising providing an encoder coupled to the apparatus, the encoder being configured to produce an external magnetic field having predetermined magnetic variations in response to motion of the encoder and the apparatus, producing a plurality of output signals in response to the external magnetic field at each of a plurality of magnetoresistive sensor elements, wherein each of the magnetoresistive sensor elements includes a sense layer having a vortex magnetization pattern, selecting first and second magnetoresistive sensor elements from the plurality of magnetoresistive sensor elements to be a first gradient unit, and producing a first differential output signal as a difference between the first and second output signals of the first and second magnetoresistive sensor elements of the gradient unit.

## BRIEF DESCRIPTION OF THE DRAWINGS

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.

FIG. 1 shows a simplified perspective view of a tunnel magnetoresistive (TMR) sensor element having a single domain state;
FIG. 2 shows a graph of a magnetoresistive transfer curve in dependence of magnetic field strength for the single domain state of the TMR sensor element of FIG. 1;
FIG. 3 shows a simplified perspective view of a TMR sensor element having a vortex state;
FIG. 4 shows a top view of a sense layer of the TMR sensor element of FIG. 3 having a vortex magnetization pattern;
FIG. 5 shows a top view of the sense layer of the TMR sensor element of FIG. 4 in which the vortex magnetization pattern is shifted in response to application of an external magnetic field;
FIG. 6 shows a graph of a magnetoresistive transfer curve in dependence of magnetic field strength for the vortex state of the TMR sensor element of FIG. 3;
FIG. 7 shows a schematic cross-section of a TMR sensor element in accordance with an embodiment;
FIG. 8 shows in a simplified and representative form an example of a system for rotation speed measurement in accordance with an embodiment;
FIG. 9 shows a graph of magnetic field input signals and magnetoresistive sensor output signals;
FIG. 10 shows an example of a system for rotation speed measurement in accordance with another embodiment;
FIG. 11 shows a block diagram of the system of FIG. 10 in accordance with an embodiment;
FIG. 12 shows a graph of magnetic field input signals and magnetoresistive sensor output signals in accordance with the example system of FIG. 10;
FIG. 13 shows an example of a system for rotation speed measurement in accordance with another embodiment;
FIG. 14 shows a graph of magnetic field input signals and magnetoresistive sensor output signals in accordance with the example system of FIG. 13;
FIG. 15 shows a block diagram of the system of FIG. 13 in accordance with an embodiment;
FIG. 16 shows a graph of example magnetic field input signals for the system of FIG. 13;
FIG. 17 shows a graph of example differential output signals for two second-order gradient configurations of the system of FIG. 13; and
FIG. 18 shows a flowchart of a speed determination process in accordance with another embodiment.

## DETAILED DESCRIPTION

In overview, the present disclosure concerns a magnetic field sensor, a system incorporating the magnetic field sensor, and methodology for measuring rotational speed of an object. More particularly, a system includes multiple magnetoresistive sensor elements, such as tunnel magnetoresistive (TMR) sensor elements, arranged in a gradient magnetic field sensing configuration. The sense layers (also referred to as free layers) of the TMR sensor elements are configured in a vortex state and are thus sensitive to in-plane magnetic fields along a single axis. Stability of the vortex state of the sensor elements may be achieved by a combination of measures including a multi-layered sense layer with a relatively thick soft magnetic material with high saturation magnetization and a relatively small diameter of the sense layer in which a compromise is achieved between manufacturability of the layer thickness and diameter. Further, stability of the sensor elements in a vortex state may be achieved by an encoder magnet and sensor layout arrangement, a second-order gradient arrangement, and the ability to detect a critical situation and flag it to the user of the sensor.

The instant disclosure is provided to further explain in an enabling fashion at least one embodiment in accordance with the present invention. The disclosure is further offered to enhance an understanding and appreciation for the inventive principles and advantages thereof, rather than to limit in any manner the invention. The invention is defined solely by the appended claims including any amendments made during the pendency of this application and all equivalents of those claims as issued.

It should be understood that the use of relational terms, if any, such as first and second, top and bottom, and the like are used solely to distinguish one from another entity or action without necessarily requiring or implying any actual such relationship or order between such entities or actions. Furthermore, some of the figures may be illustrated using various shading and/or hatching to distinguish the different elements produced within the various structural layers. These different elements within the structural layers may be produced utilizing current and upcoming microfabrication techniques of depositing, patterning, etching, and so forth. Accordingly, although different shading and/or hatching is utilized in the illustrations, the different elements within the structural layers may be formed out of the same material.

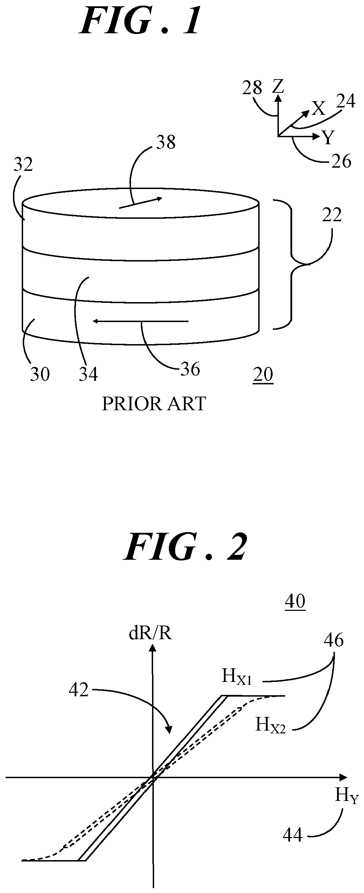

FIG. 1 shows a simplified perspective view of a tunnel magnetoresistive (TMR) sensor element 20 having a single domain state. TMR sensor element 20 typically includes a layer stack 22 of alternating non-magnetic, (anti)ferromagnetic, or ferrimagnetic layers arranged on a common substrate (not shown). Within a Cartesian coordinate system with an X-axis 24, a Y-axis 26, and a Z-axis 28, the layers of layer stack 22 extend in a plane spanned by X- and Y-axes 24, 26.

A TMR structure typically includes a metal-insulator-metal layer sandwich, (e.g., layer stack 22), in which the metal layers are magnetic and the insulator layer is very thin. In this example, layer stack 22 of TMR sensor element 20 includes magnetic layers 30, 32 separated by an electrically insulating tunnel barrier layer 34. Magnetic layer 30 may be fixed, or "pinned," to have a reference magnetization, as represented by an arrow 36. Therefore, ferromagnetic layer 30 is referred to hereinafter as reference layer 30. Magnetic layer 32 is "free" to respond to, i.e., sense, an applied magnetic field to provide a sense magnetization, represented by an arrow 38. Accordingly, magnetic layer 32 is referred to hereinafter as sense layer 32. The single domain state configuration of TMR sensor element 20 has homogeneous in-plane magnetization.

While in operation, electrical charges may pass from one side of tunnel barrier layer 34 to the other. The TMR effect expresses itself as a change of the amount of charges passing through tunnel barrier layer 34 in a given time interval for a given electrical voltage across the tunnel barrier. This effect may arise due to directional changes of the magnetization of sense layer 32 caused by the changing external magnetic field. The external magnetic field or field angle can thus be sensed by a change in the conductance (or resistance) of the sensor element.

FIG. 2 shows a graph 40 of a magnetoresistive transfer curve 42 of magnetic field strength 44, $H_Y$, for the single domain state of the TMR sensor element 20 (FIG. 1). In an example, magnetoresistive transfer curve 42 has an external stabilization field $H_{X(BIAS)}$ along X-axis 24 (FIG. 1) in accordance with current magnetoresistive speed sensors for passive encoder wheels. Transfer curve 42 shows a generally linear response with minor hysteresis. However, the sensitivity and hence the apparently measured magnetic field 44, $H_Y$, depends upon the cross-axis magnetic field strength 46, $H_{X1}$ or $H_{X2}$, in this example.

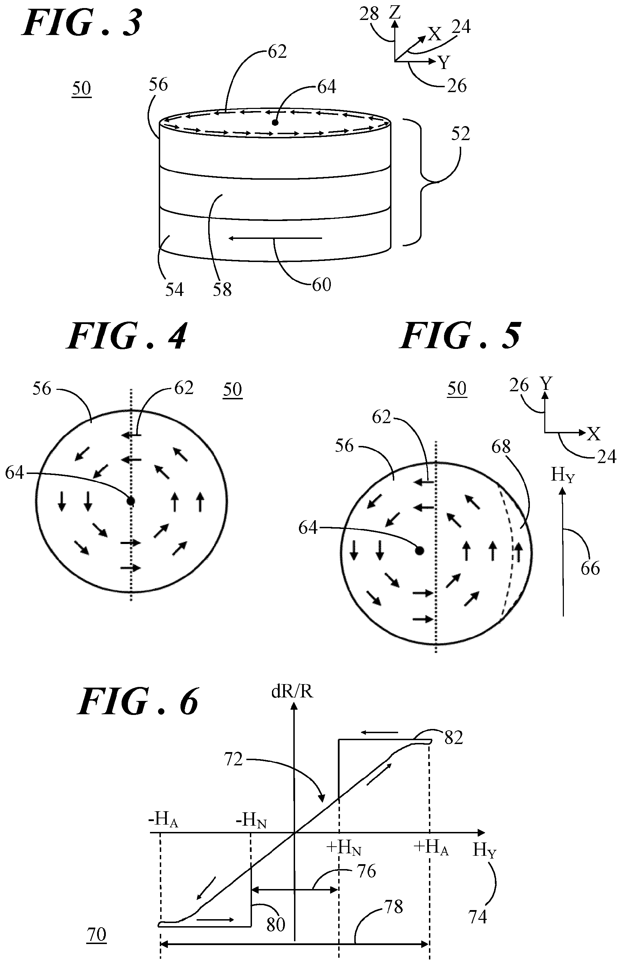

Referring now to FIG. 3, FIG. 3 shows a simplified perspective view of a TMR sensor element 50 having a vortex state. TMR sensor element 50 includes a layer stack 52 that includes a magnetic reference layer 54 and a magnetic sense layer 56 separated by an electrically insulating tunnel barrier layer 58. Again, reference layer 54 is fixed, or "pinned," to have a reference magnetization, as represented by an arrow 60. Magnetic sense layer 56 is a rotationally symmetric circular or disk-like shape. Providing sense layer 56 having a rotationally symmetric shape may lead to formation of a closed flux magnetization pattern in sense layer 56. This closed flux magnetization pattern may include a vortex magnetization pattern, where the vortex magnetization pattern may be essentially circular. In this example of the vortex state, magnetic sense layer 56 has a vortex magnetization pattern 62 in which the magnetization is characterized by a circumferential (e.g., circular) pattern and a center point 64 (also referred to as a vortex core) at which the magnetization direction points outward or inward relative to Z-axis 28. Layers of elliptic, polygonal, rectangular, or other shapes may also form a vortex state and behave similar to the example presented herein.

Referring to FIGs. 4 and 5, FIG. 4 shows a top view of sense layer 56 of TMR sensor element 50 having vortex magnetization pattern 62 and FIG. 5 shows a top view of sense layer 56 of TMR sensor element 50 in which vortex magnetization pattern 62 has shifted in response to application of an external magnetic field 66 (e.g., $H_Y$). In some embodiments, vortex magnetization pattern 62 is patterned in a circular shape, which may provide effective vortex pattern stability for isotropic layer properties. In other embodiments, this circular shape may be modified depending upon a particular application and the crystal anisotropy.

In FIG. 4, an external magnetic field is not being applied (e.g., $H_Y$=0). As such, the vortex core (e.g., center point 64) of vortex magnetization pattern 62 is centered (for example, located at the center dotted line). Application of external magnetic field 66 moves vortex magnetization pattern 62 perpendicular to external magnetic field 66. That is, vortex magnetization pattern 62 becomes off centered from the center dotted line and a net magnetization is generated. Schematically this net magnetization is indicated by an area 68 in FIG. 5. Since the magnetization structure is not rigid as assumed in first-order, the net magnetic moment will depend on the micromagnetic details of sense layer 56. However, FIGs. 4 and 5 generally demonstrate the sensing principle. Accordingly, if reference layer 54 (FIG. 3) is magnetized parallel to Y-axis 26, then the illustrated configuration generates a conductance change that is proportional to the $H_Y$ magnetic field component. Similarly, if reference layer 54 is magnetized parallel to X-axis 24, then a conductance change will be proportional to the Hx magnetic field component.

FIG. 6 shows a graph 70 of a magnetoresistive transfer curve 72 in dependence of magnetic field strength 74, $H_Y$, for the vortex state of TMR sensor element 50 (FIG. 3). Transfer curve 72 shows no cross-axis dependency in the linear range around a zero $H_Y$ magnetic field. That is, the apparent magnetic field component 74, $H_Y$, inhered from a measurement of the conductance of TMR sensor element 50 is not affected by the cross-axis magnetic field strength, Hx. Critical parameters which may describe a condition in which the vortex state exists are referred to as the nucleation field, $H_N$, where the vortex nucleates, and the annihilation field, $H_A$, where the vortex vanishes and gets destroyed again, respectively. Graph 70 further shows these vortex characteristics, i.e., nucleation field, $H_N$, and annihilation field, $H_A$.

Two different working ranges may be distinguished with respect to nucleation field, $H_N$, and annihilation field, $H_A$. A first working range, referred to herein as a vortex formation range 76 is defined by the nucleation fields $H_{N+}$ and $H_{N-}$, and may be unaffected by the magnetic history since vortex nucleation may be ensured. A second working range, referred to herein as a vortex annihilation range 78 is defined by the annihilation fields $H_{A+}$ and $H_{A-}$. As long as vortex annihilation range 78 is not exceeded (for example, by a disturbance event, such as a high magnetic field pulse), the vortex state may be preserved. In other words, the in-plane component of the magnetization, dR/R, may be shifted along curve 72 by altering the external magnetic field. However, after a disturbance event occurs outside of vortex annihilation range 78, a "reset" may be needed in order to re-form vortex magnetization pattern 62 (FIG. 3) by reducing the external magnetic field strength to a value within vortex formation range 76. In between the disturbance event and vortex reformation, the in-plane component of the magnetization, dR/R, may follow a hysteresis curve 80, 82. Thus, for relatively low external magnetic fields, there may be nearly zero hysteresis. However, for high external magnetic fields, a strong hysteresis occurs due to annihilation (at $H_A$) and nucleation (at $H_N$) of the vortex core. As a consequence, the external magnetic fields should ideally be below the nucleation field to ensure proper and safe operation in an application.

Accordingly, FIG. 6 shows a typical response for a vortex (e.g., vortex magnetization pattern 62) to a linear external magnetic field. The vortex has limited stability. The vortex can be annihilated (i.e., destroyed) at a magnetic field above $H_A$ and is nucleated only at a lower magnetic field, $H_N$, causing hysteresis. This limited stability hampers the use of vortex mode sensors in some applications (for example, automotive applications) with a large dynamic range of operation.

In accordance with embodiments described below, systems include multiple magnetoresistive sensor elements, such as TMR sensor elements 50, each of which includes magnetic sense layer 56 configured to generate vortex magnetization pattern 62 in magnetic sense layer 56 and each of which is configured to produce an output signal in response to an external magnetic field, which may be produced by an encoder magnet within a system. Vortex state magnetoresistive sensor elements (e.g., TMR sensor element 50) may be suitable candidates for use as magnetic gradiometers, due to their insensitivity to cross-axis magnetic fields and their highly linear response over a wide adjustable magnetic field range.

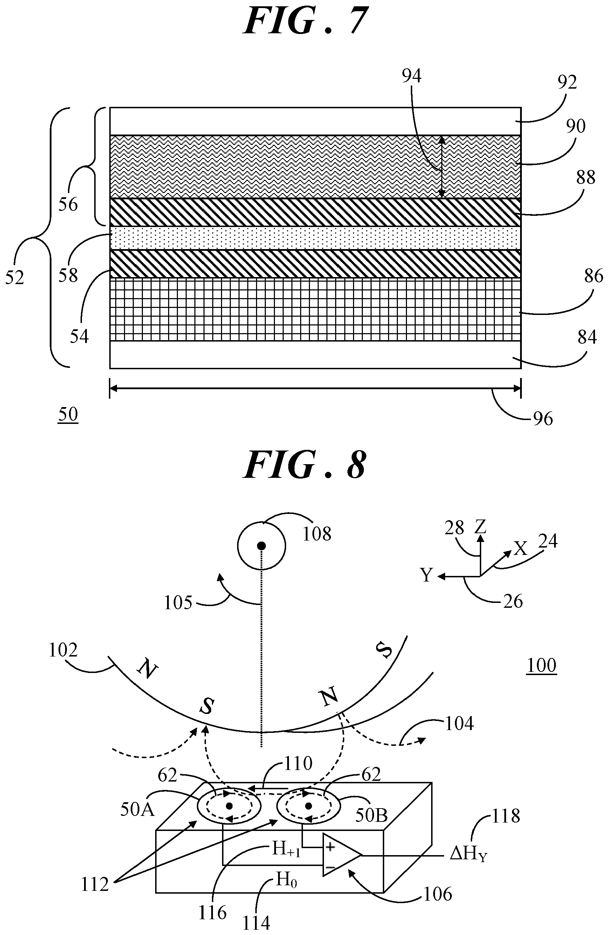

FIG. 7 shows a schematic cross-section of a TMR sensor element in accordance with an embodiment. More particularly, FIG. 7 shows a schematic cross-section of TMR sensor element 50 (also referred to as a magnetic tunnel junction or MTJ) in accordance with some embodiments. A magnetic field sensor can include a multiplicity of TMR sensor elements 50 suitably connected together. TMR sensor element 50 includes multiple structural layers, and these layers can again include multiple layers. In this example, a TMR sensor element 50 includes a bottom contact 84, which itself may include a bottom electrode, buffer, and seed layer (not distinguished herein). Electrical connections and/or a substrate (not shown) may be located below bottom contact 84.

A pinning layer 86 is formed on bottom contact 84 and magnetic reference layer 54 is formed on pinning layer 86. Pinning layer 86 may be antiferromagnetic, ferrimagnetic, or ferromagnetic material. Pinning layer 86 may also contain a synthetic antiferromagnetic or ferrimagnetic stack of layers that are magnetically coupled. Reference magnetization 60 (FIG. 3) of reference layer 54 is pinned by couplings to pinning layer 86 so that reference magnetization 60 does not change significantly with an external magnetic field. Tunnel barrier layer 58 is formed on magnetic reference layer 54. Tunnel barrier layer 58 may be a magnesium-oxide composition (MgOx), an aluminum oxide composition ($AL_2O_3$), or any other suitable electrically insulating material.

Magnetic sense layer 56 may be formed on tunnel barrier layer 58. In theory, the performance of TMR sensor element 50 may be improved by increasing the operating field range. The operating field range may be increased by judicious selection of shape, thickness, and/or materials of sense layer 56. By way of example, the operating field range becomes larger for a high saturation magnetization of the sense layer material and a high aspect ratio of the thickness to the lateral dimension (e.g., diameter) of the sense layer. However, there are process restrictions. For example, lithography processes demand a minimum diameter (e.g., above 100 nanometers) for automotive robust configurations. Additionally, the thickness of the sense layer should not be too thick in order to avoid issues related to mechanical stress or etching. Further, the magnetic material in contact with tunnel barrier layer 58 cannot be freely selected. Given the tradeoffs discussed above, sense layer 56 may be formed of layers 88, 90, 92 in some embodiments. The TMR effect is such that a component of the net magnetization of sense layer 56 is converted to a conductance if reference layer 54 is predominantly uniformly magnetized (e.g., single domain state, flower state, or similar). In some embodiments, layer 88 in contact with tunnel barrier layer 58 may be formed of a similar material as that of reference layer 54. Additionally, layer 88 may be optimized for highest resistance change (e.g., $R_{max}/R_{min}-1$) of the tunnel current through tunnel barrier layer 58. A material that may be utilized for layer 88 may be, for example, a cobalt-iron-boron (CoFeB) composition, although other suitable materials may alternatively be used.

In some embodiments, layer 90 is a magnetically-soft, ferromagnetic material layer. A magnetically-soft, ferromagnetic material is a material in which the magnetization within the material can be easily reversed. The magnetically-soft ferromagnetic material layer 90 may be a cobalt-tantalum-zirconium (CoTaZr) alloy or a nickel-iron-cobalt alloy ($Ni_{74}Fe_{10}Co_{16}$) in some embodiments. These materials have a higher saturation magnetization (e.g., a maximum possible magnetization) than nickel-iron material (e.g., Permalloy) that is used in typical AMR sensors. Additionally, these materials are uniform enough (e.g., amorphous) and contain elements that can be reasonably etched. That is, both uniformity and composition are important for a well-controlled etch process. Still further, they have low magnetostriction (e.g., a property pertaining to the change in the dimensions of a ferromagnetic body caused by a change in its state of magnetization). Low magnetostriction is important for minimizing the stress sensitivity of TMR sensor element 50.

In some embodiments, sense layer 56, is characterized by a shape and a size such that only a single vortex magnetization pattern 62 (FIG. 3) is generated within sense layer 56 in the absence of an external magnetic field. By way of example, sense layer 56 has a circular shape in some embodiments, as discussed above. Additionally, the circular magnetically-soft, ferromagnetic material layer 90 may have a thickness 94 between 20 and 60 nanometers and a diameter 96 between 150 and 500 nanometers. Although a circular shape of sense layer 56 is shown, more generally, sense layer 56 may have an elliptical shape in which a length of each of a major axis and a minor axis of the ellipse is between 150 and 500 nanometers.

Such configurations may enable effective manufacturability while concurrently achieving the characteristic of a single vortex magnetization pattern. Although sense layer 56 is described as including three layers 88, 90, 92, these layers may be built up of multiple different sublayers (e.g., to control the crystalinity, to have added capping, and growth layers, and so forth). Additionally, layer stack 52 may be inverted by processing the reference layer above the tunnel barrier layer. TMR sensor elements may be advantageously implemented herein due to their high output signal. However, alternative embodiments may implement other configurations, such as AMR or GMR with a vortex state.

FIG. 8 shows in a simplified and representative form an example of a system 100 (e.g., a speed sensor) for rotation speed measurement in which a pair of TMR sensor elements may be implemented in accordance with an embodiment. In this example, system 100 includes an encoder 102 configured to produce an external magnetic field 104 (represented by dashed arrows) having predetermined magnetic variations in response to rotation (denoted by curved arrow 105) of encoder 102. The presented alternating north (N) and south (S) pole configuration shown in FIG. 8 yields the predetermined magnetic variations. Alternative embodiments may implement a ferromagnetic gear wheel or other similar structure. Other possible magnetizations are possible, such as tooth-to-tooth with alternating north and south poles.

System 100 further includes first and second magnetoresistive sensor elements. The first and second magnetoresistive sensor elements are equivalent to TMR sensor elements 50 (FIG. 7). Therefore, they are referred to herein as a first TMR sensor element 50A and a second TMR sensor element 50B. As discussed above, each of first and second TMR sensor elements 50A and 50B includes sense layer 56 (FIG. 7) having vortex magnetization pattern 62. A processing circuit 106 is electrically coupled to first and second TMR sensor elements 50A, 50B. In this example configuration, first and second TMR sensor elements 50A, 50B are configured to measure rotational speed of encoder 102, and hence to measure the rotational speed of an apparatus to which encoder 102 is attached. In this example, the apparatus may be a shaft 108.

Single TMR sensor elements 50 are shown in connection with system 100 and other systems described below. It should be understood, however, that each TMR sensor element may represent a single TMR sensor element, a half-bridge of TMR sensor elements, a full-bridge of TMR sensor elements, multiple TMR sensor elements in series, using reference resistors, measuring currents or voltages, and so forth. Additionally, although TMR sensor elements are discussed herein, those skilled in the art will recognize that vortex structures are not limited to the TMR effect. Alternative system embodiments may implement Giant Magnetoresistive (GMR) sensor structures, Anisotropic Magnetoresistive (AMR) sensor structures, or other xMR structures.

In accordance with some embodiments, the high sensitivity of a TMR sensor is combined with the linearity of a vortex state sensor (e.g., vortex magnetization pattern 62) and a gradient sensing principle. In this example, system 100 employs a first-order gradient sensing configuration. That is, encoder 102 produces external magnetic field 104 having a component, $H_Y$, that is oriented in the plane (defined by X- and Y-axes 24, 26) of sense layer 56, and a component, Hz, that is oriented perpendicular to the plane of sense layer 56. However, the magnetic vortices (e.g., vortex magnetization pattern 62) in first and second sensor elements 50A, 50B only react to the magnetic field component, $H_Y$, in the plane of sense layer 56. As such only the component of external magnetic field 104 in the plane of sense layer 56 in a direction parallel to Y-axis 26 is sensed. Thus, first and second TMR sensor elements 50A, 50B are aligned with Y-axis 26 to detect a component of external magnetic field 104, $H_Y$, that is oriented in a first direction in the plane of sense layer 56 (e.g., and more particularly, parallel to Y-axis 26). The Y-axis component of external magnetic field 104, $H_Y$, is referred to herein as Y-axis external magnetic field 110.

In some embodiments, system 100 includes a gradient unit 112 that includes first and second TMR sensor elements 50A, 50B. First TMR sensor element 50A is configured to produce a first output signal 114, Ho, in response to Y-axis external magnetic field 110. Likewise, second TMR sensor element 50B is configured to produce a second output signal 116, H+i, in response to Y-axis external magnetic field 110. First and second output signals 114, 116 may be input to processing circuit 106. In an example, processing circuit 106 may be a difference unit configured to produce a differential output signal 118, $\Delta H_Y$, as a difference between first and second output signals 114, 116 of gradient unit 112. Further signal processing capabilities of processing circuit 106 may entail generating a speed pulse in response to differential output signal 118. For example, a speed pulse may be generated whenever differential output signal 118 crosses the zero level, e.g., differential output signal is approximately zero. The speed pulse is indicative of a speed of an apparatus (e.g., shaft 108) to which encoder 102 is coupled. As such, the rotational speed of shaft 108 may be derived by counting the speed pulses per second.

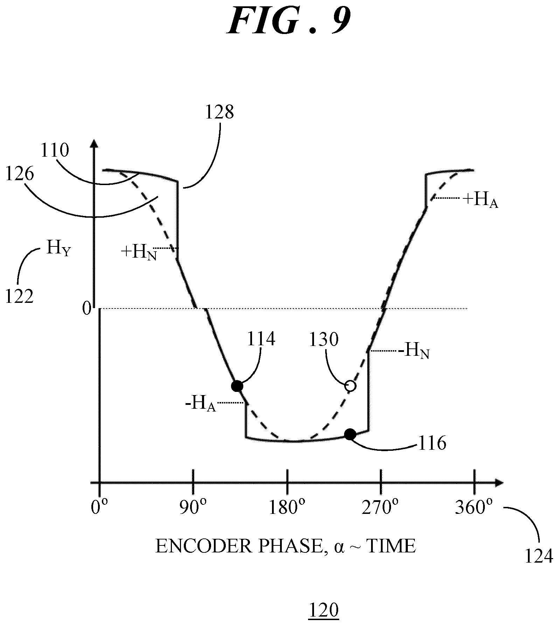

FIG. 9 shows a graph 120 of magnetic field input signals and magnetoresistive sensor output signals. In particular, graph 120 shows external magnetic field strength 122, $H_Y$, relative to encoder phase 124, $\alpha$, in which encoder phase 124 is proportional to time if encoder 102 is rotating at a constant speed. Graph 120 includes an input curve 126 (dashed line) representing Y-axis external magnetic field 110 (as the magnetic field input signal) plotted over encoder phase 124, $\alpha$. Graph 120 includes an output signal curve 128 (solid line) representing the output of a TMR sensor element 50 scaled to represent an apparent magnetic field component. Output signal curve 128 is hysteretic when vortex magnetization pattern 62 (FIG. 8) annihilates at $\pm H_A$ and nucleates at $\pm H_N$. A sensor location along Y-axis 26 (FIG. 8) corresponds to a phase shift. A first black dot represents first output signal 114 along output signal curve 128 and a second block dot represents second output signal 116 along output signal curve 128 at a given instant in time. That is, the dots move with time along output signal curve 128. A white dot on output signal curve 128 is drawn at a location where the magnetic field gradient, e.g., differential output signal 118 (FIG. 8), is zero. In other words, the white dot represents an expected signal output 130 when the difference between first and second output signals 114, 116 is zero. However, vortex magnetization pattern 62 for second TMR sensor element 50B producing second output signal 116 was annihilated. Therefore, differential output signal 118 is non-zero.

The configuration of system 100 (FIG. 8) having a single (also referred to as a first-order) gradient unit 112 may operate satisfactorily in some applications. However, external magnetic field 104 produced by encoder 102 cannot be so strong as to annihilate vortex magnetization pattern 62 in either of first and second TMR sensor elements 50A, 50B since annihilation of vortex magnetization pattern 62 may hamper the operation of the gradient-sensing speed sensor.

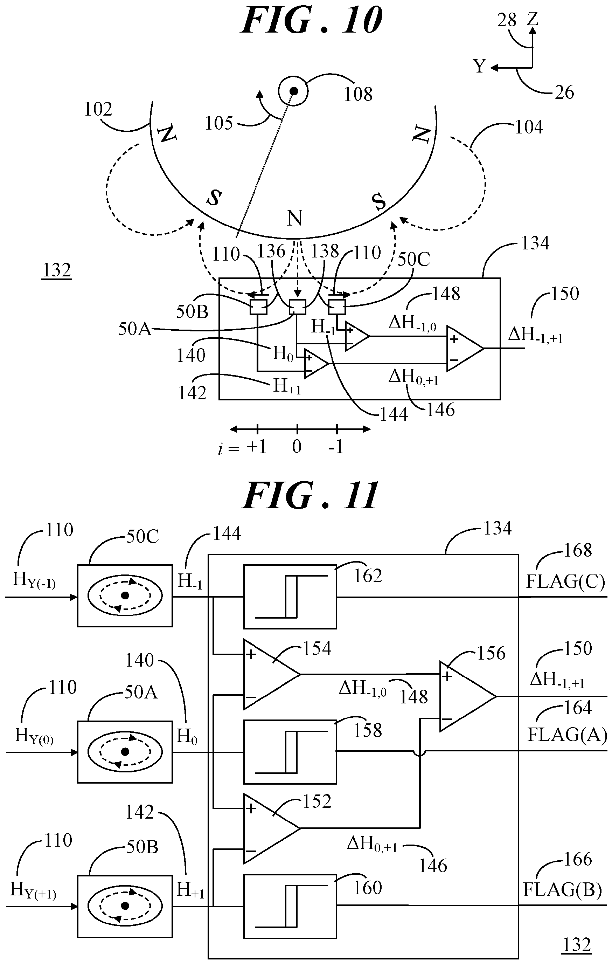

Referring now to FIG. 10, FIG. 10 shows an example of a system 132 (e.g., speed sensor) for rotation speed measurement in accordance with another embodiment. As mentioned above, system 100 (FIG. 8) employs a first-order gradient sensing configuration. In accordance with some embodiments, system 132 employs a second-order gradient sensing configuration for sensing the Y-axis component of external magnetic field 104, $H_Y$ (e.g., Y-axis external magnetic field 110). For simplicity, features that are common in each of systems 100 and 132 will be denoted by the same reference numerals.

System 132 includes encoder 102 configured to produce external magnetic field 104. In this example, system 132 further includes first, second, and third magnetoresistive sensor elements. The first, second, and third magnetoresistive sensor elements are equivalent to TMR sensor elements 50 (FIG. 7). Therefore, they are referred to herein as a first TMR sensor element 50A, a second TMR sensor element 50B, and a third TMR sensor element 50C. As discussed above, each of first, second, and third TMR sensor elements 50A, 50B, 50C includes sense layer 56 (FIG. 7) having vortex magnetization pattern 62 (FIG. 3). A processing circuit 134 is electrically coupled to first, second, and third TMR sensor elements 50A, 50B, 50C. In this example configuration, first, second, and third TMR sensor elements 50A, 50B, 50C are configured to measure rotational speed of encoder 102, and hence to measure the rotational speed of shaft 108.

In the illustrated configuration, first, second, and third TMR sensor elements 50A, 50B, 50C are aligned with one another parallel to Y-axis 26. In some embodiments, first TMR sensor element 50A is interposed between second and third TMR sensor elements 50B, 50C. Additionally, second and third TMR sensor elements 50B, 50C are spaced equidistantly from first TMR sensor element 50A in some embodiments.

System 132 includes a first gradient unit 136 of first and second TMR sensor elements 50A, 50B, and a second gradient unit 138 of first and third TMR sensor elements 50A, 50C. First TMR sensor element 50A is configured to produce a first output signal 140, Ho, in response to Y-axis external magnetic field 110. Second TMR sensor element 50B is configured to produce a second output signal 142, H+i, in response to Y-axis external magnetic field 110. Third TMR sensor element 50C is configured to produce a third output signal 144, $H_{-1}$, in response to Y-axis external magnetic field 110.

First, second, and third output signals 140, 142, 144 may be input to processing circuit 134. In an example, processing circuit 134 may be a difference unit configured to produce a first differential output signal 146, $\Delta H_{0,+1}$, as a difference between first and second output signals 140, 142 of first gradient unit 136. Likewise, processing circuit 134 may be configured to produce a second differential output signal 148, $\Delta H_{-1,0}$, as a difference between first and third output signals 140, 144. Thereafter, processing circuit 134 is configured to produce a sensor output signal 150, $\Delta^2 H_{-1,0,+1}$ (where the superscript "2" represents second-order gradient sensing) as a difference between first and second differential output signals 146, 148, as follows:

$$\Delta^2 H_{-1,0,+1} = \Delta H_{0,+1} - \Delta H_{-1,0} \qquad (1)$$

As known to those skilled in the art, in digital versus analog processing of the second-order gradient, with first differential output signal 146, $\Delta H_{0,+1} = (H_{+1}-H_0)$ and second differential output signal 148, $\Delta H_{-1,0} = (H_0-H_{-1})$, then $\Delta^2 H_{-1,0,+1} = (H_{+1}-H_0) - (H_0-H_{-1})$ is an equivalent operation to $\Delta^2 H_{-1,0,+1} = (H_{+1}+H_{-1})-2H_0$.

Further signal processing capabilities of processing circuit 106 may entail generating a speed pulse in response to sensor output signal 150. For example, a speed pulse may be generated whenever differential output signal 150 crosses the zero level, e.g., differential output signal is approximately zero. The speed pulse is indicative of a speed of an apparatus (e.g., shaft 108) to which encoder 102 is coupled. As such, the rotational speed of shaft 108 may be derived by counting the speed pulses per second. Although one example is presented herein, any weighted combination of the signals is possible to form higher order gradients and/or to shape the signal as suited for speed pulse generation.

The second-order gradient sensing configuration of system 132 advantageously centers the absolute magnetic field strength, Hi, around zero for a speed-pulse generation. As such, vortex magnetization pattern 62 (FIG. 3) of the individual first, second, and third TMR sensor elements 50A, 50B, 50C is not annihilated. The operating magnetic field range may thus be increased in system 132, as compared to system 100 (FIG. 8), with the addition of a third TMR sensor element 50.

Referring to FIG. 11 in connection with FIG. 10, FIG. 11 shows a block diagram of system 132 for magnetic field measurement in accordance with an embodiment. The block diagram is presented specifically in relation to the configuration of system 132 having first, second, and third TMR sensor elements 50A, 50B, 50C. Alternative embodiments will be discussed below. It should be recalled that the safe operational range of a magnetoresistive sensor element is limited by the instability of the vortex (e.g., vortex magnetization pattern 62) in the presence of large magnetic fields. In accordance with some embodiments, system 132 is configured to identify when any of first, second, and third TMR sensor elements 50A, 50B, 50C is subject to a critical situation. A critical situation occurs when the detected magnetic field exceeds the annihilation field and remains critical until the detected magnetic field is below the nucleation field. Thus, system 132 may be configured to detect a critical situation and flag it to a user (e.g., human or apparatus) which can take measures to mitigate the critical situation. The critical situation detection capability may be configured more for conservatively for safety critical applications in some embodiments. For example, the sensor state may be regarded as critical/uncertain whenever the nucleation field, $H_N$, is exceeded, not only when the annihilation field, $H_A$, is exceeded.

Again, system 132 includes first, second, and third TMR sensor elements 50A, 50B, 50C positioned at corresponding locations of i = 0, +1, and -1 relative to one another and configured to detect Y-axis external magnetic field 110. First and second output signals 140, 142 may be input to a first difference unit 152 to yield first differential output signal 146. First and third output signals 140, 144 may be input to a second difference unit 154 to yield second differential output signal 148. First and second differential output signals 146, 148 may be input to a third difference unit 156 to yield sensor output signal 150.

In order to detect critical situations, processing circuit 134 of system 132 further includes a first detector 158 configured to receive first output signal 140 from first TMR sensor element 50A, a second detector 160 configured to receive second output signal 142 from second TMR sensor element 50B, and a third detector 162 configured to receive third output signal 144 from third TMR sensor element 50C. Each of first, second, and third detectors 158, 160, 162 is configured to determine from the correspondingly received first, second, and third output signals 140, 142, 144 whether the associated first, second, and third TMR sensor elements 50A, 50B, 50C are operating in a safe range.

The detectors generate flagging signals. For example, first detector 158 may generate a first flag signal 164 (e.g., FLAG(A)), second detector 160 may generate a second flag signal 166 (e.g., FLAG(B)), and third detector 162 may generate a third flag signal 168 (e.g., FLAG(C)). First, second, and third detectors 158, 160, 162 may be comparators, hysteretic Schmitt-Triggers, digital circuitry after analog-to-digital conversion, or any other suitable level detector. The hysteresis may be adjusted to approximate the hysteresis of vortex magnetization pattern generation and annihilation.

Although three flag signals 164, 166, 168 are indicated herein, the three flag signals may be combined as a single signal in some embodiments. Further, all signals from TMR sensor elements 50A, 50B, 50C or from detectors 158, 160, 162 may be additionally be subject to temperature compensation.

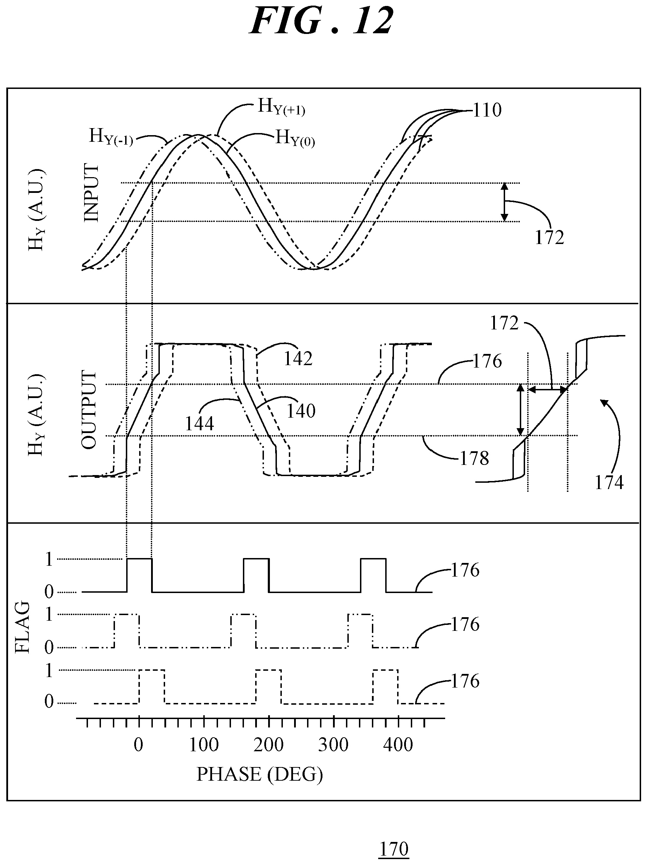

With reference to FIG. 12 in connection with FIGs. 10 and 11, FIG. 12 shows a graph 170 of magnetic field input signals and magnetoresistive sensor output signals in accordance with the example system 132. In this example, the encoder phase axis is proportional to time for a constant rotation speed. In graph 170, an input section includes Y-axis external magnetic field 110 at corresponding locations of i = 0, +1, and -1 of first, second, and third TMR sensor elements 50A, 50B, 50C. In graph 170, an output section includes first, second, and third output signals 140, 142, 144. Additionally, in graph 170, flag section includes first, second, and third flag signals 164, 166, 168. Thus, solid lines represent Y-axis external magnetic field 110, $H_{Y(0)}$, detectable at first TMR sensor element 50A, first output signal 140, and first flag signals 164. Dashed lines represent Y-axis external magnetic field 110, $H_{Y(+1)}$, detectable at second TMR sensor element 50B, second output signal 142, and second flag signals 166. Dash-dot-dot lines represent Y-axis external magnetic field 110, $H_{Y(-1)}$, detectable at third TMR sensor element 50C, third output signal 144, and third flag signals 168.

The input section of graph 170 additionally includes a safe range 172. Further, the output section of graph 170 includes safe range 172 denoted in a signal transfer curve 174 for TMR sensor elements 50A, 50B, 50C. Safe range 172 can be delineated in signal transfer curve 174 by upper and lower threshold limits 176, 178 for first, second, and third output signals 140, 142, 144. Safe range 172 indicates a region in which the signal output (e.g., first, second, and third output signals 140, 142, 144) from any of TMR sensor elements 50A, 50B, 50C is valid. Any of first, second, and third output signals 140, 142, 144 that fall outside of safe range 172 at a given instant can be considered invalid. In this example, a value of "1" for any of first, second, and third flag signals 164, 166, 168 indicates a valid signal and a value of "0" for any of first, second, and third flag signals 164, 166, 168 indicates an invalid signal. Accordingly, a critical situation is indicated for any of first, second, and third output signals 140, 142, 144 when any of the corresponding first, second, and third flag signals 164, 166, 168 is "0." In this example, a value of "1" is considered valid and a value of "0" is considered invalid. However, this could be inverted, or more flag levels could be utilized.

As mentioned above, a critical situation occurs when the detected magnetic field exceeds the annihilation field and remains critical until the detected magnetic field is below the nucleation field. However, it may be difficult to detect the exact state of the magnetic structure (e.g., TMR sensor elements 50A, 50B, 50C having vortex magnetization pattern). Further, the state of the magnetic structure may not be well defined due to magnetic hysteresis. Therefore, safe range 172 may be selected to be valid below the nucleation field ($\pm H_N$) in some embodiments.

In general, processing circuit 134 produces sensor output signal 150 as the difference between first and second differential output signals 146, 148 when all of first, second, and third TMR sensor elements 50A, 50B, 50C are operating in safe range 172 (e.g., when all of first, second, and third flag signals 164, 166, 168 are the value "1"). In some embodiments, processing circuit 134 may be further configured to discard any invalid ones of first, second, and third output signals 140, 142, 144 and produce a sensor output signal with the remaining one or more of the first, second, and third output signals 140, 142, 144 after the invalid ones of the first, second, and third output signals 140, 142, 144 have been discarded. By way of example, if one of second and third output signals 142, 144 is invalid, it may be possible to utilize the corresponding first or second differential output signal 146, 148 as sensor output signal 150. Alternatively, the zero crossing of the absolute field value of TMR sensor element 50A may be used as a fallback.

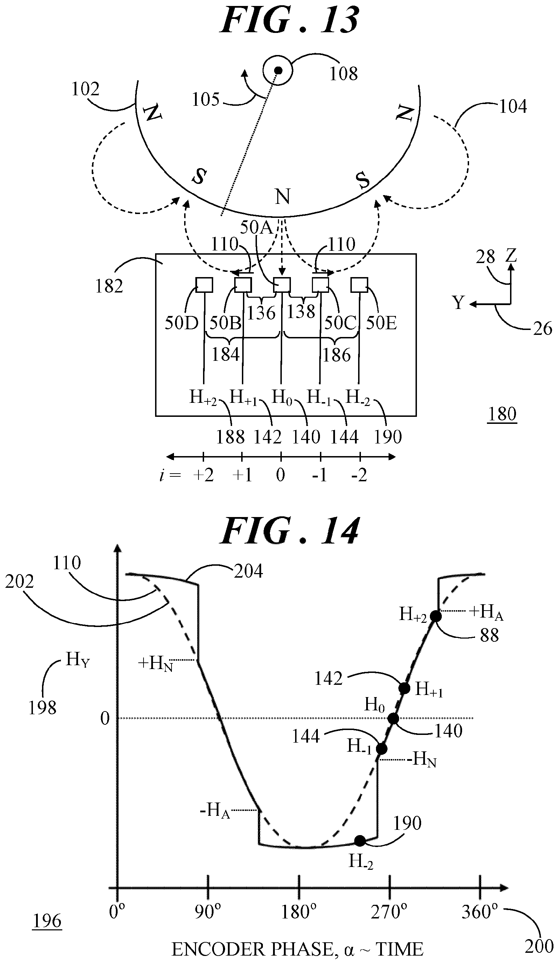

Note, however, that in this example, there is no overlapping safe range 172 of second and third output signals 142, 144 for second and third TMR sensor elements 50B and 50C for strong Y-axis external magnetic field 110 (e.g., $H_{Y(+1)}$ and $H_{Y(-1)}$) which could result in second and third output signals 142, 144 being above upper threshold limit 176 or below lower threshold limit 178. In other words, second and third flag signals 166, 168 will not have a value of "1" at the same time. Other techniques, discussed below in connection with FIGs. 13-15, may be implemented in some embodiments to remedy this issue.

Referring now to FIG. 13, FIG. 13 shows an example of a system 180 (e.g., speed sensor) for rotation speed measurement in accordance with another embodiment. System 180 is an expansion of system 132 (FIG. 10). Therefore, features that are common to each of systems 132 and 180 will be denoted by the same reference numerals.

System 180 includes encoder 102 configured to produce external magnetic field 104. In this example, system 180 further includes first, second, and third TMR sensor elements 50A, 50B, 50C, a fourth TMR sensor element 50D, and a fifth TMR sensor element 50E. Like TMR sensor elements 50A, 50B, 50C, each of fourth and fifth TMR sensor elements 50D, 50E also includes sense layer 56 (FIG. 7) having vortex magnetization pattern 62 (FIG. 3). A processing circuit 182 is electrically coupled to first, second, third, fourth, and fifth TMR sensor elements 50A, 50B, 50C, 50D, 50E. Again, first, second, third, fourth, and fifth TMR sensor elements 50A, 50B, 50C, 50D, 50E are configured to measure rotational speed of encoder 102, and hence to measure the rotational speed of shaft 108.

In the illustrated configuration, TMR sensor elements 50A, 50B, 50C, 50D, 50E are aligned with one another parallel to Y-axis 26. First TMR sensor element 50A is interposed between second and third TMR sensor elements 50B, 50C. Fourth TMR sensor element 50D is adjacent to second TMR sensor element 50B at a location i = +2 and fifth TMR sensor element 50E is adjacent to third TMR sensor element 50C at a location i = -2. Again, second and third TMR sensor elements 50B, 50C are spaced equidistantly from first TMR sensor element 50A in some embodiments. Additionally, fourth and fifth TMR sensor elements 50D, 50E are spaced equidistantly from first TMR sensor element 50A in some embodiments.

System 180 includes first gradient unit 136 of first and second TMR sensor elements 50A, 50B, and second gradient unit 138 of first and third TMR sensor elements 50A, 50C. System 180 additionally includes a third gradient unit 184 of first and fourth TMR sensor elements 50A, 50D and a fourth gradient unit 186 of first and fifth TMR sensor elements 50A, 50E. As discussed previously, first TMR sensor element 50A is configured to produce first output signal 140, Ho, second TMR sensor element 50B is configured to produce second output signal 142, H+i, and third TMR sensor element 50C is configured to produce third output signal 144, $H_{-1}$, in response to Y-axis external magnetic field 110. Additionally, fourth TMR sensor element 50D is configured to produce a fourth output signal 188, $H_{+2}$, and fifth TMR sensor element 50E is configured to produce a fifth output signal 190, $H_{-2}$, in response to Y-axis external magnetic field 110.

Referring to FIG. 14 in connection with FIG. 13, FIG. 14 shows a graph 196 of magnetic field input signals and magnetoresistive sensor output signals in accordance with system 180. In particular, graph 196 shows external magnetic field strength 198, $H_Y$, relative to encoder phase 200, $\alpha$, in which encoder phase 200 is proportional to time if encoder 102 is rotating at a constant speed. Graph 196 includes an input signal curve 202 (dashed line) representing Y-axis external magnetic field 110 (as the magnetic field input signal) plotted over encoder phase 200, $\alpha$. Graph 196 further includes an output signal curve 204 (solid line) representing the output of a TMR sensor element 50 scaled to represent an apparent magnetic field component. Output signal curve 204 is hysteretic when vortex magnetization pattern 62 (FIG. 3) annihilates at $\pm H_A$ and nucleates at $\pm H_N$.

A sensor location along Y-axis 26 (FIG. 3) corresponds to a phase shift. A first black dot represents first output signal 140 along output signal curve 204, a second block dot represents second output signal 142, a third black dot represents third output signal 144, a fourth black dot represents fourth output signal 188, and a fifth block dot represents fifth output signal 190 along output signal curve 204 all at a given instant in time. That is, the dots move with time along output signal curve 204. In this example, vortex magnetization pattern 62 for fifth TMR sensor element 50E producing fifth output signal 190 was annihilated and vortex magnetization pattern 62 for fourth TMR sensor element 50D is close to annihilation.

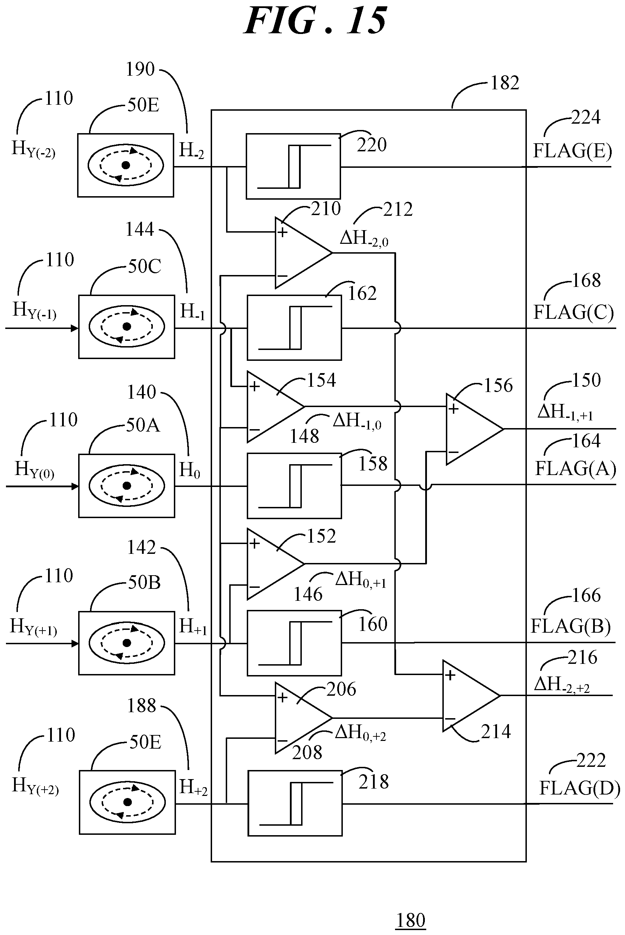

Referring to FIG. 15 in connection with FIGs. 13-14, FIG. 15 shows a block diagram of system 180 in accordance with an embodiment. The block diagram is presented specifically in relation to the configuration of system 180 having first, second, and third, fourth, and fifth TMR sensor elements 50A, 50B, 50C, 50D, 50E. In accordance with some embodiments, system 180 is configured to detect when any of first, second, third, fourth, and fifth TMR sensor elements 50A, 50B, 50C, 50D, 50E is subject to a critical situation, flag it to a user (e.g., human or apparatus) which can take measures to mitigate the critical situation.

Again, system 132 includes first, second, and third TMR sensor elements 50A, 50B, 50C, 50D, 50E positioned at corresponding locations of i = 0, +1, -1, +2, -2 relative to one another and configured to detect Y-axis external magnetic field 110. First and second output signals 140, 142 may be input to first difference unit 152 to yield first differential output signal 146. First and third output signals 140, 144 may be input to second difference unit 154 to yield second differential output signal 148. First and second differential output signals 146, 148 may be input to third difference unit 156 to yield sensor output signal 150, $\Delta^2 H_{-1,0,+1}$, as explained above using equation (1). Additionally, first and fourth output signals 140, 188 may be input to a fourth difference unit 206 to yield a third differential output signal 208, $\Delta H_{0,+2}$. First and fifth output signals 140, 190 may be input to a fifth difference unit 210 to yield a fourth differential output signal 212, $\Delta H_{0,-2}$. Third and fourth differential output signals 208, 212 may be input to a sixth difference unit 214 to yield another second-order sensor output signal 216, $\Delta^2 H_{-2,0,+2}$, in accordance with the following equation:

$$\Delta^2 H_{-2,0,+2} = \Delta H_{0,+2} - \Delta H_{-2,0} \tag{2}$$

Further signal processing capabilities of processing circuit 182 may entail generating a speed pulse in response to either one of sensor output signals 150, 216. The above presented combinations of sensor signals (e.g., $\Delta^2 H_{-1,0,+1}$ and $\Delta^2 H_{-2,0,+2}$) are provided as examples. However, it should be understood that other combinations are possible such as, for example, $\Delta^2 H_{-2,-1,+2} = \Delta H_{+1,+2} - \Delta H_{-2,-1}$, which is also a second-order gradient sensing configuration.

In order to detect critical situations, processing circuit 182 of system 180 further includes first detector 158 configured to receive first output signal 140 from first TMR sensor element 50A, second detector 160 configured to receive second output signal 142 from second TMR sensor element 50B, and third detector 162 configured to receive third output signal 144 from third TMR sensor element 50C. Processing circuit 182 further include a fourth detector 218 configured to receive fourth output signal 188 from fourth TMR sensor element 50D and a fifth detector 220 from fifth TMR sensor element 50E. Each of first, second, third, fourth, and fifth detectors 158, 160, 162, 218, 220 is configured to determine from the correspondingly received first, second, third, fourth, and fifth output signals 140, 142, 144, 188, 190 whether the associated first, second, third, fourth, and fifth TMR sensor elements 50A, 50B, 50C, 50D, 50E are operating in a safe range.

Again, detectors generate flagging signals. For example, first detector 158 may generate first flag signal 164 (e.g., FLAG(A)), second detector 160 may generate second flag signal 166 (e.g., FLAG(B)), and third detector 162 may generate third flag signal 168 (e.g., FLAG(C)). Likewise, fourth detector 218 may generate a fourth flag signal 222 (e.g., FLAG(D)) and fifth detector 220 may generate a fifth flag signal 224 (e.g., FLAG(E)). As described above, detectors 158, 160, 162, 218, 220 may be comparators, hysteretic Schmitt-Triggers, digital circuitry after analog-to-digital conversion, or any other suitable level detector. The hysteresis may be adjusted to approximate the hysteresis of vortex magnetization pattern generation and annihilation.

The configuration of system 180 including five TMR sensor elements 50A, 50B, 50C, 50D, 50E, thereby yielding four gradient units 136, 138, 184, 186 may enable the detection of a safe operating range (e.g., safe range 172 of FIG. 12) by switching to other sensor combinations depending upon the field strength of the encoder. This enables the use of more sensitive sensors, instead of sensors that always work (e.g., the nucleation field is greater than the maximum external magnetic field) but have weak signal. This may be advantageous for enabling better signal to noise ratios, a wider range of usable encoder magnets, lower power consumption, and so forth.

In a second-order gradient sensing implementation, the center TMR sensor element plus two identically spaced TMR sensor elements would be used. In system 180, the second-order gradient sensor combinations would be first, second, and third TMR sensor elements 50A, 50B, 50C corresponding to locations i = +1, 0, -1 or first, fourth, and fifth TMR sensor elements 50A, 50D, 50E corresponding to locations i = +2, 0, -2. The selected combination of TMR sensor elements would be based on the detected flagging signals (e.g., first, second, third, fourth, and fifth flag signals 164, 166, 168, 222, 224). In an example, first, second, and third TMR sensor elements 50A, 50B, 50C may be utilized in the second-order gradient sensing configuration when encoder 102 produces a relatively strong external magnetic field 104. Alternatively, first, fourth, and fifth TMR sensor elements 50A, 50B, 50E may be utilized in the second-order gradient sensing configuration when encoder 102 produces a relatively weak external magnetic field 104.

Accordingly, system 180 that includes the five TMR sensor elements 50A, 50B, 50C, 50D, 50E (thereby yielding four gradient units 136, 138, 184, 186) can enable switching between two sensor configurations (e.g., low external magnetic field and high external magnetic field). This switching may be done during the first rotation of encoder 102 and shaft 180 after system start-up. During further operation, processing circuit 182 of system 180 can determine whether the selection was correct by utilizing flag signals 164, 166, 168, 222, 224 or if there are other safety issues (e.g., significant noise, no valid signal, and so forth). Still further, if no second-order gradient selection can be made, a fallback may be to switch to a first-order gradient selection or even to amplitude zero crossing.

The configuration of system 180 includes five TMR sensor elements 50 (which may be single TMR sensor elements, half-bridge of TMR sensor elements, full-bridges of TMR sensor elements, multiple TMR sensor elements connected in series, and so forth). It should be further understood that alternative systems may include additional TMR sensor elements (or other magnetoresistive sensor elements) at other locations (e.g., i = +3, 0, -3, i = +4, 0, -4, and so forth) with non-equidistant spacing or in several sensor orientations, and correspondingly additional difference units and detectors. It should also be understood that sensor elements with different properties can be used, e.g., with different diameters. Such a variant could employ 2x3 sensor elements where the second set of sensor elements would be more sensitive by featuring a larger size. It should also be understood that the sensor elements may be sensitive to various field orientations and can be place where it is best suited for a given application (e.g., not necessarily in a single row with equidistant spacing).

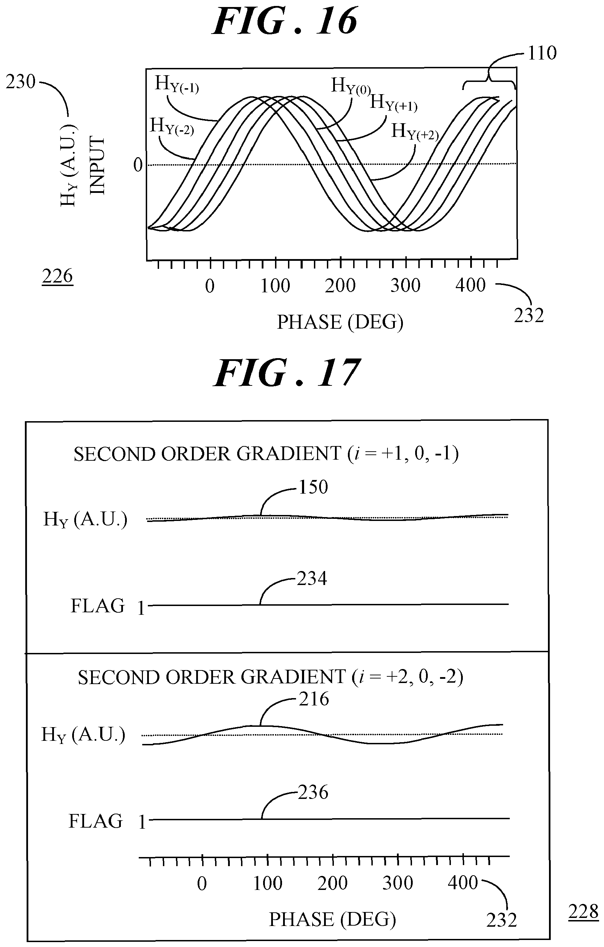

Referring to FIGs. 16 and 17, FIG. 16 shows a graph 226 of example magnetic field input signals for system 180 (FIG. 13) and FIG. 17 shows a graph 228 of example differential output signals for two second-order gradient sensing configurations of the system 180 for a relatively weak encoder magnetic field strength. Graphs 226, 228 are provided to demonstrate the selection of second-order gradient sensing configurations possible in system 180. Thus, reference should be made concurrently with Figs. 13 and 15 in connection with the following discussion.

Graph 226 shows external magnetic field strength 230, $H_Y$, relative to encoder phase 232, $\alpha$, in which encoder phase 232 is proportional to time if encoder 102 is rotating at a constant speed. In graph 226, Y-axis external magnetic field 110 is shown at corresponding locations of i = 0, +1, -1, +2, -2 of first, second, third, fourth, and fifth TMR sensor elements 50A, 50B, 50C, 50D, 50E. Thus, graph 226 shows undisturbed relatively small external magnetic fields at five sensor locations.

Graph 228 shows a second-order gradient configuration of first, second, and third TMR sensor elements 50A, 50B, 50C at locations i = 0, +1, -1 and the corresponding sensor output signal 150. A flag signal 234 represents first, second, and third flag signals 150, 166, 168 combined by an AND operation. In the examples presented above, a flag signal of "1" denotes a valid signal. Thus, flag signal 234 of "1" indicates that each of first, second, and third output signals 140, 142, 144 is a valid signal. Similarly, graph 228 shows a second-order gradient configuration of first, fourth, and fifth TMR sensor elements 50A, 50D, 50E at locations i = 0, +2, -2 and the corresponding sensor output signal 216.

A flag signal 236 represents first, fourth, and fifth flag signals 150, 222, 224 combined by an AND operation. Flag signal 236 is also "1" thereby indicating that each of first, fourth, and fifth output signals 140, 188, 190 is a valid signal. In this example, sensor output signal 216 is significantly stronger than sensor output signal 150. Therefore, second output signal 216 may be preferred and processing circuit 182 may switch to the second-order gradient configuration that includes first, fourth, and fifth TMR sensor elements 50A, 50B, 50E.

Of course, other situations may arise when any of the flag signals are "0" thereby indicating that the associated output signals are invalid. As such, a selection may be made to discard any invalid signals and produce the sensor output signal with the remaining valid one or more of the output signals, as discussed above.

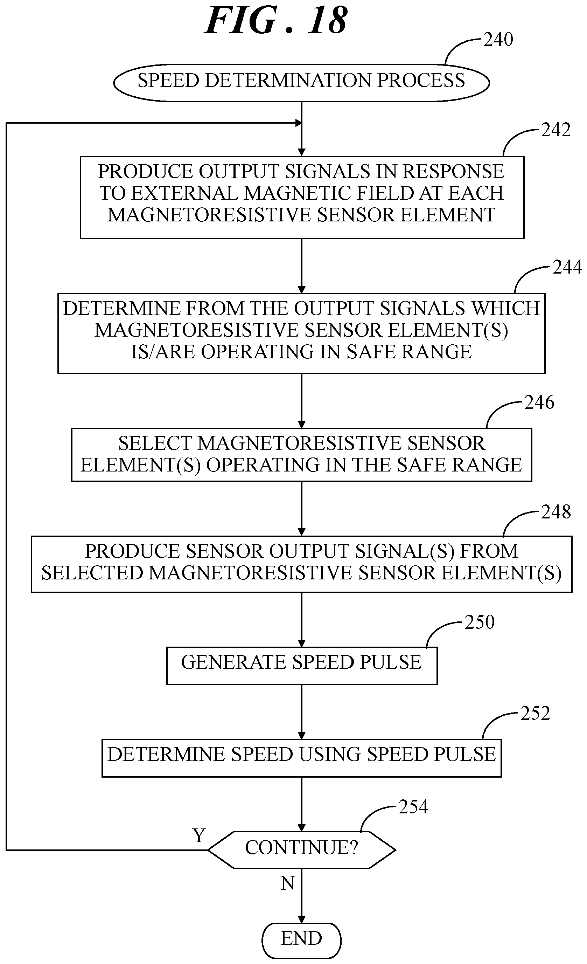

Referring now to FIG. 18, FIG. 18 shows a flowchart of a speed determination process 240 in accordance with another embodiment. Speed determination process 240 summarizes the operations that may be executed within any of systems 100 (FIG. 8), 132 (FIG. 10), 180 (FIG. 13), or another system having a greater quantity of magnetoresistive sensors. However, for simplicity, reference can be made to system 180 (FIGs. 13 and 15) in connection with the following description. As such, encoder 102 coupled to shaft 108 is provided, in which encoder 102 is configured to produce external magnetic field 104 having predetermined magnetic variations (the presented alternating north (N) and south (S) pole configuration of encoder 102 yields the predetermined magnetic variations). External magnetic field 104 has a component, the Y-axis external magnetic field 110, that may be detectable by TMR sensor elements having the vortex magnetization pattern.

At a block 242, output signals (e.g., first, second, third, fourth, and fifth output signals 140, 142, 144, 188, 190) are produced in response to Y-axis external magnetic field 110 at each of a plurality of magnetoresistive sensor elements having a vortex magnetization pattern in the sense layer (e.g., first, second, third, fourth, and fifth TMR sensor elements 50A, 50B, 50C, 50D, 50E). At a block 244, a determination is made from the output signals as to which magnetoresistive sensor element(s) is/are operating in the safe range (e.g., safe range 172 of FIG. 12).

At a block 246, magnetoresistive sensor elements are selected that are operating in the safe range and at a block 248 sensor output signals (e.g., sensor output signals 150 or 216) are produced from the selected magnetoresistive sensor element(s). Thereafter, at a block 250, a speed pulse may be generated at detected zero crossings as discussed above and at a block 252 the rotational speed is determined using the speed pulse. That is, the rotational speed of shaft 108 may be derived by counting the speed pulses per second. At a query block 254, a determination is made as to whether process 240 should continue. For example, continued execution of speed determination process 240 may occur while shaft 108 continues to rotate and may be discontinued when shaft 108 is no longer rotating. When execution of speed determination process 240 is to continue, process control loops back to black 242. Otherwise, speed determination process 240 ends.

It should be understood that certain ones of the process blocks depicted in FIG. 18 may be performed in parallel with each other or with performing other processes. In addition, the particular ordering of the process blocks depicted in FIG. 18 may be modified, while achieving substantially the same result. Accordingly, such modifications are intended to be included within the scope of the inventive subject matter.

Embodiments disclosed herein entail a magnetic field sensor, systems incorporating the magnetic field sensor, and methodology for measuring rotational speed of an object are disclosed herein. Each of the systems includes multiple magnetoresistive sensor elements, such as tunnel magnetoresistive (TMR) sensor elements, arranged in a gradient magnetic field sensing configuration. The sense layers (also referred to as free layers) of the TMR sensor elements are configured in a vortex state and are thus sensitive to in-plane magnetic fields along a single axis. Stability of the vortex state of the sensor elements may be achieved by a combination of measures including a multi-layered sense layer with a relatively thick soft magnetic material with high saturation magnetization and a relatively small diameter and thickness of the sense layer in which a compromise is achieved between manufacturability of the layer thickness and diameter. Further, stability of the vortex state may be achieved by an encoder magnet and sensor layout arrangement, a second-order gradient arrangement, and the ability to detect a critical situation and flag it to the user of the sensor.

This disclosure is intended to explain how to fashion and use various embodiments in accordance with the invention rather than to limit the true, intended, and fair scope and spirit thereof. The foregoing description is not intended to be exhaustive or to limit the invention to the precise form disclosed. Modifications or variations are possible in light of the above teachings. The embodiment(s) was chosen and described to provide the best illustration of the principles of the invention and its practical application, and to enable one of ordinary skill in the art to utilize the invention in various embodiments and with various modifications as are suited to the particular use contemplated. All such modifications and variations are within the scope of the invention as determined by the appended claims, as may be amended during the pendency of this application for patent, and all equivalents thereof, when interpreted in accordance with the breadth to which they are fairly, legally, and equitably entitled.

**REFERENCE NUMBERS**

| | |
|---|---|
| 20 | tunnel magnetoresistive (TMR) sensor element |
| 22 | layer stack |
| 24 | X-axis |
| 26 | Y-axis |
| 28 | Z-axis |
| 30 | pinned layer |
| 32 | sense/free layer |
| 34 | tunnel barrier layer |
| 36 | reference magnetization |
| 38 | sense magnetization |
| 40 | graph |
| 42 | magnetoresistive transfer curve |
| 44 | magnetic field strength, $H_Y$ |
| 46 | cross-axis magnetic field strength , $H_{X1}$ or $H_{X2}$ |
| 48 | - |
| 50 | TMR sensor element |
| 52 | layer stack |
| 54 | magnetic pinned layer |
| 56 | magnetic sense layer |
| 58 | tunnel barrier layer |
| 60 | reference magnetization |
| 62 | vortex magnetization pattern |
| 64 | center point |
| 66 | external magnetic field |
| 68 | area/net magnetization |
| 70 | graph |
| 72 | magnetoresistive transfer curve |
| 74 | magnetic field strength, $H_Y$ |
| 76 | vortex formation range |
| 78 | vortex annihilation range |
| 80 | hysteresis curve |
| 82 | hysteresis curve |
| 84 | bottom contact |
| 86 | pinning layer |
| 88 | layer |
| 90 | layer |
| 92 | layer |
| 94 | thickness |
| 96 | diameter |
| 98 | - |
| 100 | system |
| 102 | encoder |
| 104 | external magnetic field |
| 105 | direction of rotation |
| 106 | processing circuit |
| 108 | shaft |
| | |
| 110 | Y-axis external magnetic field |
| 112 | gradient unit |
| 114 | first output signal, Ho |
| 116 | second output signal, $H_{+1}$ |
| 118 | differential output signal $\Delta H_Y$ |
| 120 | graph |
| 122 | external magnetic field strength |
| 124 | encoder phase, $\alpha$ |
| 126 | input curve |
| 128 | output signal curve |
| 130 | expected signal output |

| | |
|---|---|
| 132 | system |
| 134 | processing circuit |
| 136 | first gradient unit |
| 138 | second gradient unit |
| 140 | first output signal, Ho |
| 142 | second output signal, $H_{+1}$ |
| 144 | third output signal, $H_{-1}$ |
| 146 | first differential output signal, $\Delta H_{0,+1}$ |
| 148 | second differential output signal, $\Delta H_{-1,0}$ |
| 150 | sensor output signal, $\Delta H_{-1,+1(2nd\ Order)}$ |
| 152 | first difference unit |
| 154 | second difference unit |
| 156 | third difference unit |
| 158 | first detector |
| 160 | second detector |
| 162 | third detector |
| 164 | first flag signal |
| 166 | second flag signal |
| 168 | third flag signal |
| 170 | graph |
| 172 | safe range |
| 174 | signal transfer curve |
| 176 | upper threshold limit |
| 178 | lower threshold limit |
| 180 | system |
| 182 | processing circuit |
| 184 | third gradient unit |
| 186 | fourth gradient unit |
| 188 | fourth output signal, $H_{+2}$ |
| 190 | fifth output signal, $H_{-2}$ |
| 192 | - |
| 194 | - |
| 196 | graph |
| 198 | external magnetic field strength, $H_Y$ |
| 200 | encoder phase |
| 202 | input signal curve (dashed line) |
| 204 | output signal curve (solid line) |
| 206 | fourth difference unit |
| 208 | third differential output signal, $\Delta H_{0,+2}$ |
| 210 | fifth difference unit |
| 212 | fourth differential output signal, $\Delta H_{0,-2}$ |
| 214 | sixth difference unit |
| 216 | sensor output signal, $\Delta H_{-2,+2}$ |
| 218 | fourth detector |
| 220 | fifth detector |
| 222 | fourth flag signal, FLAG(D) |
| 224 | fifth flag signal, FLAG(E) |
| 226 | graph |
| 228 | graph |
| 230 | external magnetic field strength, $H_Y$ |
| 232 | encoder phase, $\alpha$ |
| 234 | flag signal |
| 236 | flag signal |
| 238 | - |
| 240 | speed determination process |
| 242 | block |
| 244 | block |
| 246 | block |

248    block
250    block
252    block
254    q. block

## Claims

1. A sensor comprising:

   a first magnetoresistive sensor element configured to produce a first output signal in response to an external magnetic field;
   a second magnetoresistive sensor element configured to produce a second output signal in response to the external magnetic field, wherein the first and second magnetoresistive sensor elements form a gradient unit, each of the first and second magnetoresistive sensor elements includes a sense layer having a vortex magnetization pattern; and
   a processing circuit electrically coupled to the first and second magnetoresistive sensor elements, wherein the processing circuit is configured to produce a differential output signal as a difference between the first and second output signals of the first and second magnetoresistive sensor elements of the gradient unit.

2. The sensor of claim 1 wherein each of the first and second magnetoresistive sensor elements comprises a tunnel magnetoresistive, TMR, sensor element, the TMR sensor element including:

   a reference layer having a uniformly magnetized reference magnetization;
   the sense layer including a magnetically-soft, ferromagnetic material; and
   an electrically insulating tunnel junction interposed between the reference and sense layers.

3. The sensor of claim 2 wherein the magnetically-soft, ferromagnetic material comprises one of $CoTa_xZr_y$ and $NiFe_x$-$Co_y$, wherein each of x and y can be an integer or a fractional number.

4. The sensor of any preceding claim, wherein the sense layer of each of the first and second magnetoresistive sensor elements is **characterized by** a shape and a size such that only a single vortex magnetization pattern is generated within the sense layer in the absence of the external magnetic field.

5. The sensor of claim 4 wherein the shape and the size of the sense layer of each of the first and second magnetoresistive sensor elements exhibits an elliptical shape having a thickness between 20 and 60 nanometers and a length of each of a major axis and a minor axis of the elliptical shape being between 150 and 500 nanometers.

6. The sensor of any preceding claim further comprising:

   a first detector configured to receive the first output signal from the first magnetoresistive sensor element and determine from the first output signal whether the first magnetoresistive sensor element is operating in a predetermined safe range; and
   a second detector configured to receive the second output signal from the second magnetoresistive sensor element and determine from the second output signal whether the second magnetoresistive sensor element is operating in the predetermined safe range, wherein:
   the processing circuit is electrically coupled with the first and second detectors, the processing circuit being further configured to produce a first flag when the first magnetoresistive sensor element is not operating in the safe range, preferably less than a nucleation field for the vortex magnetization pattern, thereby indicating that the first output signal is invalid and produce a second flag when the second magnetoresistive sensor element is not operating in the safe range thereby indicating that the second output signal is invalid.

7. The sensor of any preceding claim wherein the sensor is a speed sensor, and the processing circuit is further configured to generate a speed pulse indicative of a speed of an apparatus in response to the differential output signal.

8. The sensor of any preceding claim wherein the gradient unit is a first gradient unit, the differential output signal is a first differential output signal, and the sensor further comprises:
   a third magnetoresistive sensor element configured to produce a third output signal in response to the external magnetic field, wherein a sense layer of the third magnetoresistive sensor element has the vortex magnetization pattern and the first and third magnetoresistive sensor elements form a second gradient unit, and wherein: the processing circuit is electrically coupled to the third magnetoresistive sensor element and is configured to produce at least one of a second differential output signal as the difference between the second and third output signals of the second gradient unit, and a sensor output signal as a difference between the first and second differential output signals.

9. The sensor of claim 8 wherein the first, second, and third magnetoresistive sensor elements are aligned with one another parallel to the first direction, the first magnetoresistive sensor element is interposed between the second and third magnetoresistive sensor elements, and the second and third magnetoresistive sensor elements are equidistant from the first magnetoresistive sensor element.

10. The sensor of claim 8 further comprising:

a first detector configured to receive the first output signal from the first magnetoresistive sensor element and determine from the first output signal whether the first magnetoresistive sensor element is operating in a safe range, the safe range being less than a nucleation field for the vortex magnetization pattern;
a second detector configured to receive the second output signal from the second magnetoresistive sensor element and determine from the second output signal whether the second magnetoresistive sensor element is operating in the safe range; and
a third detector configured to receive the second output signal from the second magnetoresistive sensor element and determine from the second output signal whether the second magnetoresistive sensor element is operating in the safe range, wherein:
the processing circuit is electrically coupled with the first, second, and third detectors, the processing circuit being further configured to produce a first flag when the first magnetoresistive sensor element is not operating in the safe range thereby indicating that the first output signal is invalid, produce a second flag when the second magnetoresistive sensor element is not operating in the safe range thereby indicating that the second output signal is invalid, and produce a third flag when the third magnetoresistive sensor element is not operating in the safe range thereby indicating that the third output signal is invalid.

11. The sensor of claim 10 wherein the processing circuit is further configured to:

produce a sensor output signal as the difference between the first and second differential output signals when all of the first, second, and third magnetoresistive sensor elements are operating in the safe range;
discard any invalid ones of the first, second, and third output signals; and
produce the sensor output signal with a remaining one or more of the first, second, and third output signals after the invalid ones of the first, second, and third output signals have been discarded.

12. The sensor of claim 10 further comprising:

a fourth magnetoresistive sensor element configured to produce a fourth output signal in response to the external magnetic field, wherein a sense layer of the fourth magnetoresistive sensor element has the vortex magnetization pattern;
a fifth magnetoresistive sensor element configured to produce a fifth output signal in response to the external magnetic field, wherein a sense layer of the fifth magnetoresistive sensor element has the vortex magnetization pattern in the sense layer;
a fourth detector configured to receive the fourth output signal from the fourth magnetoresistive sensor element and determine from the fourth output signal whether the fourth magnetoresistive sensor element is operating in the safe range; and
a fifth detector configured to receive the second output signal from the second magnetoresistive sensor element and determine from the fifth output signal whether the fifth magnetoresistive sensor element is operating in the safe range, and wherein:

the processing circuit is further electrically coupled to the fourth and fifth magnetoresistive sensor elements, the processing circuit being further configured to:

produce a fourth flag when the fourth magnetoresistive sensor element is not operating in the safe range thereby indicating that the fourth output signal is invalid;

produce a fifth flag when the fifth magnetoresistive sensor element is not operating in the safe range thereby indicating that the fifth output signal is invalid; and
discard any invalid ones of the first, second, third output signals, fourth, and fifth output signals; and

produce the sensor output signal with a remaining one or more of the first, second, third, fourth, and fifth output signals after the invalid ones of the first, second, and third output signals have been discarded.

**13.** A method of determining speed of an apparatus comprising:

providing an encoder coupled to the apparatus, the encoder being configured to produce an external magnetic field having predetermined magnetic variations in response to motion of the encoder and the apparatus;
producing a plurality of output signals in response to the external magnetic field at each of a plurality of magnetoresistive sensor elements, wherein each of the magnetoresistive sensor elements includes a sense layer having a vortex magnetization pattern;
selecting first and second magnetoresistive sensor elements from the plurality of magnetoresistive sensor elements to be a first gradient unit; and
producing a first differential output signal as a difference between the first and second output signals of the first and second magnetoresistive sensor elements of the gradient unit.

**14.** The method of claim 13 further comprising:

selecting the first magnetoresistive sensor element and a third magnetoresistive sensor element from the plurality of magnetoresistive sensor elements to be a second gradient unit, wherein the first, second, and third magnetoresistive sensor elements are aligned with one another parallel to the first direction, the first magnetoresistive sensor element is interposed between the second and third magnetoresistive sensor elements, and the second and third magnetoresistive sensor elements are equidistant from the first magnetoresistive sensor element;
producing a second differential output signal as the difference between the second and third output signals of the second gradient unit;
producing a sensor output signal as a difference between the first and second differential output signals; and
generating a speed pulse indicative of a speed of the apparatus coupled to the encoder when the sensor output signal is zero.

**15.** The method of claim 13 or 14 wherein:

for each of the magnetoresistive sensor elements, determining from the corresponding one of the output signals whether the magnetoresistive sensor element is operating in a predetermined safe range; and
the selecting operation selects the first and second magnetoresistive sensor elements from those of the plurality of magnetoresistive sensors operating in the safe range.

# FIG . 1

28 Z
X 24
Y
26

38

32

22

30 34 36 20

PRIOR ART

# FIG . 2

40

dR/R

42

H$_{X1}$

46

H$_{X2}$

H$_Y$

44

# FIG . 3

# FIG . 4

# FIG . 5

# FIG . 6

# *FIG . 7*

# *FIG . 8*

# FIG . 9

ENCODER PHASE, α ~ TIME

120

# FIG . 10

# FIG . 11

# FIG . 12

170

## FIG . 13

## FIG . 14

# FIG . 15

180

# FIG . 16

# FIG . 17

# FIG. 18

SPEED DETERMINATION PROCESS ⟶ 240

↓

PRODUCE OUTPUT SIGNALS IN RESPONSE TO EXTERNAL MAGNETIC FIELD AT EACH MAGNETORESISTIVE SENSOR ELEMENT ⟶ 242

↓

DETERMINE FROM THE OUTPUT SIGNALS WHICH MAGNETORESISTIVE SENSOR ELEMENT(S) IS/ARE OPERATING IN SAFE RANGE ⟶ 244

↓

SELECT MAGNETORESISTIVE SENSOR ELEMENT(S) OPERATING IN THE SAFE RANGE ⟶ 246

↓

PRODUCE SENSOR OUTPUT SIGNAL(S) FROM SELECTED MAGNETORESISTIVE SENSOR ELEMENT(S) ⟶ 248

↓

GENERATE SPEED PULSE ⟶ 250

↓

DETERMINE SPEED USING SPEED PULSE ⟶ 252

↓

CONTINUE? ⟶ 254

Y ⟶ (loop back)

N ↓

END